# EUROPÄISCHE PATENTSCHRIFT

(11) **EP 3 463 871 B1**
(45) Veröffentlichungstag und Bekanntmachung des Hinweises auf die Patenterteilung: **30.08.2023**
(21) Anmeldenummer: 16744671.5
(22) Anmeldetag: 05.07.2016
(51) Int. Cl.: B32B 18/00, C04B 35/83, C04B 37/00, H01L 21/00

(54) **VERFAHREN ZUR HERSTELLUNG EINER TRÄGERPLATTE UND TRÄGERPLATTE**
METHOD TO MAKE A SUBSTRATE AND SUBSTRATE
METHODE DE FABRICATION D'UN SUBSTART ET SUBSTRAT

(30) Priorität: 03.06.2016 DE 102016110333
(43) Veröffentlichungstag der Anmeldung: 10.04.2019
(73) Patentinhaber: Schunk Kohlenstofftechnik GmbH, 35452 Heuchelheim (DE)
(72) Erfinder: VOLLMER, Andreas, 35452 Heuchelheim (DE); SCHNEIDER, Martin, 35444 Biebertal (DE)
(74) Vertreter: advotec.
(86) Internationale Anmeldenummer: PCT/EP2016/065872
(87) Internationale Veröffentlichungsnummer: WO 2017/207068

(56) Entgegenhaltungen:
- EP-A2- 0 399 548
- EP-A2- 2 065 109
- JP-A- H1 149 578
- US-A1- 2014 170 370
- US-B1- 6 489 027

## Beschreibung

Die Erfindung betrifft eine Trägerplatte und ein Verfahren zur Herstellung einer Trägerplatte zur Aufnahme und Handhabung von Halbleitererzeugnissen oder Wafer, wobei aus Kohlenstofffasern ausgebildete Fasergewebelagen zu einem Stapel angeordnet werden, wobei die Fasergewebelagen mit einem Harz imprägniert werden, wobei das Harz ausgehärtet und pyrolysiert wird, wobei nachfolgend der Stapel grafitiert wird.

Derart hergestellte Trägerplatten sind hinreichend bekannt und werden regelmäßig zur Handhabung von Wafern oder ähnlichen Halbleitererzeugnissen verwendet. In den sich flächig erstreckenden Trägerplatten sind eine Vielzahl von Ausnehmungen ausgebildet, die zur Aufnahme der Halbleitererzeugnisse dienen. Die Trägerplatten werden zum Transport, zur Lagerung und zum Einsatz in beispielsweise einem Ofen zur Behandlung der Halbleitererzeugnisse verwendet. Eine Trägerplatte sollte dabei möglichst dünn sein um eine hohe Packungsdichte an Halbleitererzeugnissen in einem Ofen erzielen zu können und gleichzeitig eine hohe Stabilität und Temperaturbeständigkeit aufweisen. Die Trägerplatte wird daher aus einem Stapel von Fasergewebelagen aus Kohlenstofffasern in einer pyrolysierten Harzmatrix hergestellt, wobei der Stapel beziehungsweise die Trägerplatte grafitiert wird. Vor dem Grafitieren erfolgt eine mechanische Bearbeitung des Stapels, beispielsweise durch Fräsen von Aufnahmen für die Halbleitererzeugnisse.

Bei den verwendeten Fasergewebelagen werden sogenannte Filamentgarne mit beispielsweise 12000 Einzelfasern (12 K-Filamentgarnen), die zu einem Garn zusammengefasst sind, verwendet. Alternativ können derartige Fasergewebelagen auch mit der Angabe tex klassifiziert werden. Ein tex steht dabei für ein Gewicht von 1 Gramm pro 1000 Meter für Tausend Einzelfasern eines Garns. Fasergewebe mit 12 K-Filamentgarnen sind gegenüber beispielsweise 6 K-Filamentgarnen kostengünstig erhältlich und leicht zu verarbeiten.

Die in dem Stapel angeordneten Fasergewebelagen können nach der Anordnung zu dem Stapel mit Harz imprägniert werden, oder es kann vorgesehen sein, mit Harz vorimprägnierte Fasergewebelagen, sogenannte Prepregs, zur Ausbildung des Stapels zu verwenden. Der mit Harz imprägnierte beziehungsweise getränkte Stapel wird zum beispielsweise Aushärten des Harzes gepresst, so dass ein im Wesentlichen formstabiles Vorprodukt der Trägerplatte entsteht. Die nachfolgende Pyrolyse des Harzes und eine Grafitierung erfolgt in einem Ofen.

In der JP H11 49578 A ist offenbart, einen Faserformling, der aus graphitierten Kohlenstoff-Kurzfasern oder -Langfasern gebildet wird. Der poröse Faserformling wird mit einem Harz imprägniert, das durch Erhitzen in einer inerten Atmosphäre graphitiert wird, wodurch die Karbonisierung und Graphitierung durchge-führt wird. Die Stufe der Graphitierungsbehandlung zur Durchführung der Karbonisierung und Graphitierung durch Freisetzung von Spaltgasen nach der Graphitierung und weiterer Impräg-nierung des Faserformlings mit dem zu graphitierenden Harz durch Erhitzen in einer inerten Atmosphäre wird dabei mehrmals wiederholt. Weiterer Stand der Technik ist den Druckschriften US 2014/170370 A1, US 6 489 027 B1 sowie EP 0 399 548 A2 zu entnehmen.

Anstelle von Harz kann auch Pech als ein Matrixmaterial verwendet werden. Pech ermöglicht eine besonders gute, mechanische Bearbeitbarkeit der Trägerplatte beziehungsweise des Vorprodukts. Auch kann mit Pech als Matrixmaterial eine gegenüber Harz höhere Ausbeute an Kohlenstoff bei einer Pyrolyse erzielt werden. Bei einer Verwendung von Pech als Matrixmaterial ist es jedoch nachteilig, dass es sich bei Pech um eine gesundheitsschädliche Chemikalie handelt, deren Verwendung im Produktionsprozess vermieden werden sollte. Darüber hinaus sind Platten mit 12 K-Filamentgarnen und Harz als Matrixmaterial nur eingeschränkt mechanisch gut bearbeitbar. Hier reißen die Kohlenstofffasern aus und es kann zu Ausfransungen beziehungsweise an einer Oberfläche hervorstehenden Kohlenstofffasern nach einer mechanischen Bearbeitung durch beispielsweise Fräsen kommen. Dieser Effekt tritt insbesondere dann auf, wenn das Garn in Richtung einer Ebene der mechanischen beziehungsweise spanenden Bearbeitung orientiert verläuft.

Der vorliegenden Erfindung liegt daher die Aufgabe zugrunde, ein Verfahren zur Herstellung einer Trägerplatte sowie eine Trägerplatte vorzuschlagen, das beziehungsweise die eine gute spanende Bearbeitbarkeit ermöglicht und auf eine Verwendung von Pech verzichtet.

Diese Aufgabe wird durch ein Verfahren mit den Merkmalen des Anspruchs 1, eine Trägerplatte mit den Merkmalen des Anspruchs 16 und eine Verwendung einer solchen Trägerplatte gelöst.

Bei dem erfindungsgemäßen Verfahren zur Herstellung einer Trägerplatte zur Aufnahme und Handhabung von Halbleitererzeugnissen oder Wafer, werden aus Kunststofffasern ausgebildete Fasergewebelagen zu einem Stapel angeordnet, wobei die Fasergewebelagen mit einem Harz imprägniert werden, wobei das Harz ausgehärtet und pyrolysiert wird, wobei nachfolgend der Stapel grafitiert wird, wobei eine erste Fasergewebelage des Stapels aus einem ersten Fasergewebe mit Filamentgarnen gleich oder größer 12 K und eine zweiten Fasergewebelage des Stapels aus einem zweiten Fasergewebe mit Filamentgarnen gleich oder gleich 6 K ausgebildet wird, wobei mittels einer spanenden Bearbeitung des Stapels eine Ausnehmung zur Aufnahme eines Halbleitererzeugnisses ausgebildet wird, wobei die spanende Bearbeitung zumindest in einer Ebene des zweiten Fasergewebes erfolgt.

Wie sich herausgestellt hat, sind die Fasergewebelagen mit 6 K Filamentgarnen mechanisch gut bearbeitbar, derart, dass keine Kohlenstofffasern ausreißen und an einer Oberfläche der Trägerplatte, die beispielsweise durch Fräsen bearbeitet wurde, hervorstehen. So kann dann auch auf eine Verwendung von Pech als Matrixmaterial verzichtet werden. Nachteilig ist jedoch, dass die 6 K-Filamentgarne vergleichsweise teurer sind als 12 K-Filamentgarne und sich die Trägerplatte dadurch verteuern würde. Da die 6 K-Filamentgarne jedoch auch eine höhere Stabilität beziehungsweise Biegefestigkeit der Trägerplatte gewährleisten, kann auf Fasergewebelagen verzichtet werden, was eine eventuelle Kostensteigerung durch die Verwendung der 6 K-Filamentgarne kompensieren kann. Auch dadurch, dass weiterhin Harzmaterial verwendet werden kann, müssen keine besonderen Schutzmaßnahmen, wie bei der Herstellung der Trägerplatte mit beispielsweise Pech, ergriffen werden. Darüber hinaus kann die Trägerplatte gegebenenfalls auch dünner ausgebildet werden, so dass eine höhere Packungsdichte in beispielsweise einem Ofen zur Behandlung von Halbleitererzeugnissen erzielbar ist. Eine spanende Bearbeitung der Trägerplatte kann prinzipiell an der ersten Fasergewebelage und der zweiten Fasergewebelage erfolgen, wobei dann die zweite Fasergewebelage vorzugsweise so orientiert beziehungsweise angeordnet ist, dass die aufzunehmenden Halbleitererzeugnisse mit der zweiten Fasergewebelage in Kontakt gelangen. So kann sichergestellt werden, dass die Halbleitererzeugnisse mit Oberflächen der Trägerplatte in Kontakt gelangen, die qualitativ hochwertig sind beziehungsweise die keine aufgespreizten oder hervorstehenden Kunststofffasern aufweisen.

Erfindungsgemäß ist mittels einer spanenden Bearbeitung des Stapels eine Ausnehmung zur Aufnahme eines Halbleitererzeugnisses ausgebildet, wobei die spanende Bearbeitung zumindest in einer Ebene des zweiten Fasergewebes erfolgt. Gleichwohl kann auch vorgesehen sein, dass die spanende Bearbeitung auch in einer Ebene des ersten Fasergewebes erfolgt. Wesentlich dabei ist dann jedoch, dass das erste Fasergewebe beziehungsweise die von dem ersten Fasergewebe ausgebildete Oberfläche der Trägerplatte nicht für einen Kontakt mit Halbleitererzeugnissen vorgesehen ist. Eine spanende Bearbeitung erfolgt vorzugsweise ausschließlich in der Ebene des zweiten Fasergewebes. Auch kann vorgesehen sein, die spanende Bearbeitung in unterschiedlichen Stadien des Herstellungsprozesses der Trägerplatte vorzunehmen, wobei die Trägerplatte beziehungsweise ein Vorprodukt der Trägerplatte als ein starrer, bearbeitbarer Körper ausgebildet sein muss. So kann eine spanende Bearbeitung nach Aushärten des Harzes, nach der Pyrolyse und/oder nach der Grafitierung durchgeführt werden.

Das erste Fasergewebe kann mit Filamentgarnen gleich oder größer 800 tex und das zweite Fasergewebe mit Filamentgarnen gleich oder kleiner 400 tex ausgebildet werden.

Die Fasergewebelagen können so zu dem Stapel angeordnet werden, dass eine erste Schicht der Trägerplatte mit dem ersten Fasergewebe und eine zweite Schicht der Trägerplatte mit dem zweiten Fasergewebe ausgebildet werden kann. So wird es möglich, die Fasergewebelagen in Schichten voneinander so zu differenzieren, dass die zweite Schicht mit dem zweiten Fasergewebe auf der Seite der Trägerplatte angeordnet ist, die mit den Halbleitererzeugnissen in Kontakt gelangt und auch für eine mechanische Bearbeitung vorgesehen ist. Nachteilig ist hier jedoch, dass es aufgrund der unterschiedlichen Filamentgarne zu einem Verzug der Trägerplatte beziehungsweise des Vorprodukts bei der Wärmebehandlung im Ofen kommen kann. Beispielsweise kann die Trägerplatte dann leicht gebogen sein, wodurch die Trägerplatte dann auch nicht mehr nutzbar wäre. Eine Ausbildung der Trägerplatte alleine aus 6 K-Filamentgarnen, die diesen möglichen Effekt verhindern würde, würde die Kosten zur Herstellung der Trägerplatte jedoch wieder unverhältnismäßig erhöhen.

Neben der Ausbildung der Trägerplatte aus alleine zwei Schichten können zwei zweite Schichten aus dem zweiten Fasergewebe ausgebildet werden, wobei die aus dem ersten Fasergewebe gebildete erste Schicht dann zwischen den zweiten Schichten aus dem zweiten Fasergewebe angeordnet werden kann. Dabei kann vorgesehen sein, dass die zwei zweiten Schichten eine übereinstimmende Dicke aufweisen. So kann dann auch verhindert werden, dass es zu einem unerwünschten Verzug der Trägerplatte bei einer Wärmebehandlung in einem Ofen kommt. Die zwei zweiten Schichten bilden demnach jeweils Oberflächen der Trägerplatte aus. Optional kann natürlich auch vorgesehen sein, die Trägerplatte aus weiteren Schichten aus den betreffenden Fasergeweben auszubilden und/oder zur Ausbildung von anderen Schichten weitere Filamentgarne zu verwenden, die sich von den erfindungsgemäß verwendeten Filamentgarnen unterscheiden.

Die erste Fasergewebelage kann mit einem Leinwand-Fasergewebe und die zweite Fasergewebelage mit einem Köper-Fasergewebe ausgebildet werden. Die Verwendung unterschiedlicher Fasergewebe zur Ausbildung der Fasergewebelagen kann einen Verzug der Trägerplatte beziehungsweise eines Vorprodukts der Trägerplatte bei einer Wärmebehandlung in einem Ofen verhindern. Ein durch die Verwendung der 6 K-Filamentgarne möglicherweise bewirkter Verzug der Trägerplatte wird dann durch das Köper-Fasergewebe wieder kompensiert beziehungsweise abgeschwächt.

Das erste Fasergewebe kann mit einem Gewichts- oder Volumenanteil von 2/3 bis 3/4 und das zweite Fasergewebe von 1/3 bis 1/4 zur Ausbildung der Trägerplatte verwendet werden. Das erste Fasergewebe weist dann den größeren Anteil im Vergleich zum zweiten Fasergewebe an der Trägerplatte auf. Dies ist insofern vorteilhaft, da das erste Fasergewebe kostengünstiger ist und überwiegend zur biegesteifen Ausbildung der Trägerplatte beiträgt. Das zur mechanischen Verarbeitung vorgesehene zweite Fasergewebe kann dann nur mit einem minimal erforderlichen Anteil an der Trägerplatte entsprechend der Erfordernisse der mechanischen Bearbeitung eingesetzt werden, um die Kosten der Trägerplatte möglichst gering zu halten.

Die Fasergewebe können mit einer wechselnden Orientierung eines Faserverlaufs relativ zueinander zu dem Stapel angeordnet werden. Beispielsweise kann dann ein multiaxialer Faserverlauf in dem Stapel ausgebildet werden. Dadurch können eventuell richtungsabhängige Eigenschaften der Trägerplatte, wie eine Biegesteifigkeit, beeinflusst werden. Beispielsweise kann vorgesehen sein den Faserverlauf der Fasergewebelagen in dem Stapel jeweils relativ zueinander um einen Winkel bezogen auf eine Hochachse des Stapels und gegebenenfalls in Abhängigkeit einer Anzahl von Fasergewebelagen anzuordnen.

Weiter kann die Ausnehmung so ausgebildet werden, dass die Ausnehmung als eine Tasche in einer Oberseite der Trägerplatte ausgebildet ist, oder die Ausnehmung kann so ausgebildet sein, dass diese als eine Durchgangsöffnung die Trägerplatte vollständig durchdringt.

In beiden Fällen kann darüber hinaus vorgesehen sein, dass an dem zweiten Fasergewebe mittels Fräsen eine Fase und/oder ein Absatz an der Ausnehmung ausgebildet wird. Eine Unter- und/oder Oberseite der Trägerplatte kann demnach im Bereich der Ausnehmung eine umlaufende Fase an einer Oberkante der Ausnehmung aufweisen. Der an der Ausnehmung ausgebildete Absatz kann zur Auflage eines Halbleitererzeugnisses, wie beispielsweise eines Wafers, dienen. Der Absatz kann ebenfalls wie die Fase oder zusammen mit dieser die Ausnehmung umgeben beziehungsweise diese selbst ausbilden. Dabei kann der Absatz relativ zu einer Ebene der Oberfläche der Trägerplatte parallel oder auch unter einem Winkel von wenigen Grad ausgebildet sein.

Weiter ist es vorteilhaft, wenn die Trägerplatte frei von Pech ausgebildet wird. Bei der Herstellung einer vollständig pechfreien Trägerplatte müssen daher auch keine besonderen Sicherheitsvorkehrungen für den Umgang mit Pech beachtet werden, was eine kostengünstige Herstellung der Trägerplatte ermöglicht.

Vorzugsweise kann als ein Harz ein Phenolharz verwendet werden. Ein Phenolharz weist eine geringere Ausbeute an Kohlenstoff nach einem Pyrolysieren in einem relativen Vergleich mit Pech auf. Dieser Nachteil kann jedoch auch dadurch aufgewogen werden, dass das zweite Fasergewebe eine stabilere Ausbildung der Trägerplatte ermöglicht.

Nach der Pyrolyse und vor der Grafitierung kann eine Nachverdichtung des Stapels mit Harz erfolgen. Dabei kann die Pyrolyse und/oder Grafitierung wiederholt durchgeführt werden. Beispielsweise kann zunächst eine erste Grafitierung und dann eine Nachverdichtung mit einer weiteren Grafitierung durchgeführt werden. Dadurch wird es möglich eine Porosität des Materials des Stapels noch weiter zu verringern.

Optional kann auch vorgesehen sein, den grafitierten Stapel mittels Gasphasenabscheidung mit Kohlenstoff zu infiltrieren und/oder zu beschichten. So kann im Rahmen eines CVI- und/oder CVD-Verfahrens ein Auffüllen von Poren in dem Kohlenstoff der Trägerplatte mit Pyrokohlenstoff durchgeführt werden, wobei auch eine Beschichtung einer Oberfläche der Trägerplatte mit dem Pyrokohlenstoff erfolgen kann. Die Trägerplatte kann dadurch gegen eine unerwünschte Aufnahme von Wasser geschützt werden, wodurch ein sonst zyklisch notwendiger Reinigungsprozess für die Trägerplatte vermieden werden kann, da diese dann kaum Feuchtigkeit aus einer Ofenatmosphäre aufnehmen kann. Die Beschichtung wirkt dann in Art einer Oberflächenversiegelung der Trägerplatte, da gegebenenfalls offene Porenmaterialien der Trägerplatte geschlossen werden können.

Um ein Verziehen der Trägerplatte beziehungsweise eines Vorprodukts der Trägerplatte bei der Herstellung derselben zu verhindern, kann während des Pyrolysierens und/oder Graftitierens der Stapel bereichsweise mit einer Kraft beaufschlagt werden. Der Stapel kann dann entgegen einer zu erwartenden Durchbiegung beziehungsweise einem Verzug fixiert werden, so dass der Stapel nach der Wärmebehandlung die gewünschte Ebene ausbildet beziehungsweise plane Form einnimmt. Dabei hat es als vorteilhaft herausgestellt, den Stapel bereichsweise mit Grafitelementen zu beschweren. Da die Grafitelemente keine Reaktanten beinhalten, erfolgt auch keine chemische Beeinflussung der Materialien des Stapels während einer Wärmebehandlung.

Erfindungsgemäß ist die Verwendung eines mit einem Harz imprägnierten Stapels mit einer ersten Fasergewebelage aus einem ersten Fasergewebe aus Kohlenstofffasern mit Filamentgarnen gleich oder größer 12 K und einer zweiten Fasergewebelage aus einem zweiten Fasergewebe aus Kohlenstofffasern mit Filamentgarnen gleich oder kleiner 6 K zur Ausbildung einer Trägerplatte zur Aufnahme und Handhabung von Halbleitererzeugnissen vorgesehen, wobei mittels einer spanenden Bearbeitung des Stapels eine Ausnehmung zur Aufnahme eines Halbleitererzeugnisses ausgebildet wird, wobei die spanende Bearbeitung zumindest in einer Ebene des zweiten Fasergewebes erfolgt. Weitere Ausführungsformen möglicher Verwendungen ergeben sich aus den Merkmalsbeschreibungen der auf den Verfahrensanspruch 1 rückbezogenen Unteransprüche.

Die erfindungsgemäße Trägerplatte zur Aufnahme und Handhabung von Halbleitererzeugnissen oder Wafer, ist aus zu einem Stapel angeordneten Fasergewebelagen aus Kohlenstofffasern ausgebildet, wobei die Trägerplatte mit einer ausgehärteten und pyrolysierten Harzmatrix zum Stapel ausgebildet und grafitiert ist, wobei eine erste Fasergewebelage des Stapels aus einem ersten Fasergewebe mit Filamentgarnen gleich oder größer 12 K und eine zweite Fasergewebelage des Stapels aus einem zweiten Fasergewebe mit Filamentgarnen gleich oder kleiner 6 K ausgebildet ist, wobei mittels einer spanenden Bearbeitung des Stapels eine Ausnehmung zur Aufnahme eines Halbleitererzeugnisses ausgebildet ist, wobei die spanende Bearbeitung zumindest in einer Ebene des zweiten Fasergewebes erfolgt ist. Zu den Vorteilen der erfindungsgemäßen Trägerplatte wird auf die Vorteilsbeschreibung des erfindungsgemäßen Verfahrens verwiesen. Weitere vorteilhafte Ausführungsformen einer Trägerplatte ergeben sich aus den auf den Verfahrensanspruch 1 rückbezogenen Unteransprüchen.

Nachfolgend werden bevorzugte Ausführungsformen der Erfindung unter Bezugnahme auf die beigefügten Zeichnungen näher erläutert.

Es zeigen:
- **Fig. 1**: eine perspektivische Ansicht einer ersten Ausführungsform einer Trägerplatte;
- **Fig. 2**: eine Teilschnittansicht einer zweiten Ausführungsform einer Trägerplatte;
- **Fig. 3**: eine Teilschnittansicht einer dritten Ausführungsform einer Trägerplatte;
- **Fig. 4**: eine Draufsicht der Trägerplatte aus **Fig. 1**;
- **Fig. 5**: eine Teilansicht der Trägerplatte aus **Fig. 4**;
- **Fig. 6**: eine Teilschnittansicht der Trägerplatte aus **Fig. 4** entlang einer Linie IV-IV;
- **Fig. 7**: eine vierte Ausführungsform einer Trägerplatte in einer Draufsicht;
- **Fig. 8**: eine Teilschnittansicht der Trägerplatte aus **Fig. 7** entlang einer Linie VIII-VIII;
- **Fig. 9**: eine perspektivische Ansicht einer fünften Ausführungsform einer Trägerplatte;
- **Fig. 10**: eine Teilansicht der Trägerplatte aus **Fig. 9**;
- **Fig. 11**: eine Teilschnittansicht der Trägerplatte aus **Fig. 10** entlang einer Linie XI-XI.

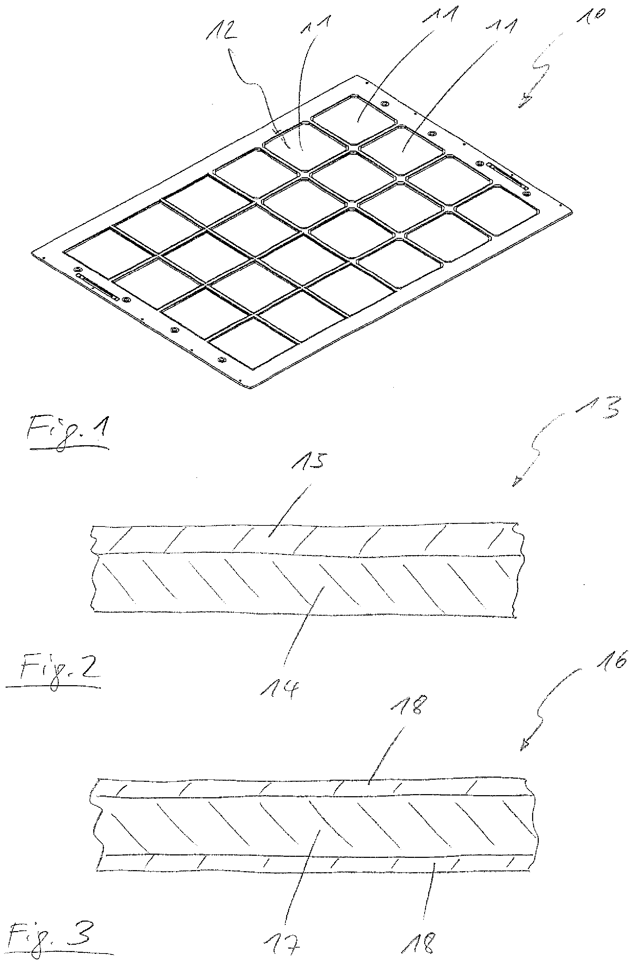

Die **Fig. 1** zeigt eine perspektivische Ansicht einer Trägerplatte 10, wobei in der Trägerplatte 10 eine Vielzahl von Durchgangsöffnungen 11, Ausnehmungen 12 zur Aufnahme von Halbleitererzeugnissen ausbilden. Die Trägerplatte 10 wurde aus zu einem Stapel angeordneten Fasergewebelagen aus Kohlenstofffasern ausgebildet, die hier nicht näher sichtbar sind. Weiter wurde die Trägerplatte mit einer ausgehärteten und pyrolysierten Harzmatrix des Stapels ausgebildet und grafitiert. Insbesondere ist eine erste Fasergewebelage des Stapels aus einem ersten Fasergewebe mit Filamentgarnen gleich oder größer 12 K und einer zweiten Fasergewebelage des Stapels aus einem zweiten Fasergewebe mit Filmamentgarnen gleich oder kleiner 6 K ausgebildet.

Die **Fig. 2** zeigt einen stark vergrößerten Teilschnitt einer Trägerplatte 13 aus der ersichtlich ist, dass die Trägerplatte 13 aus einer ersten Schicht 14 mit einem hier nicht sichtbaren ersten Fasergewebe und einer zweiten Schicht 15 mit einem zweiten Fasergewebe ausgebildet ist. Auch hier weist das erste Fasergewebe 12 K-Filamentgarne und das zweite Fasergewebe 6 K-Filamentgarne auf. Insbesondere ist die erste Schicht 14 dicker ausgebildet als die zweite Schicht 15, wobei die erste Schicht elf Fasergewebelagen und die zweite Schicht drei Fasergewebelagen aufweist.

Die **Fig. 3** zeigt eine weitere Trägerplatte 16, die im Unterschied zur Trägerplatte aus **Fig. 2** eine erste Schicht 17 und zwei zweiten Schichten 18, die die erste Schicht 17 zwischen sich aufnehmen, aufweist. Auch hier ist die erste Schicht 17 dicker ausgebildet, als eine Summe einer Dicke der zwei zweiten Schichten 18.

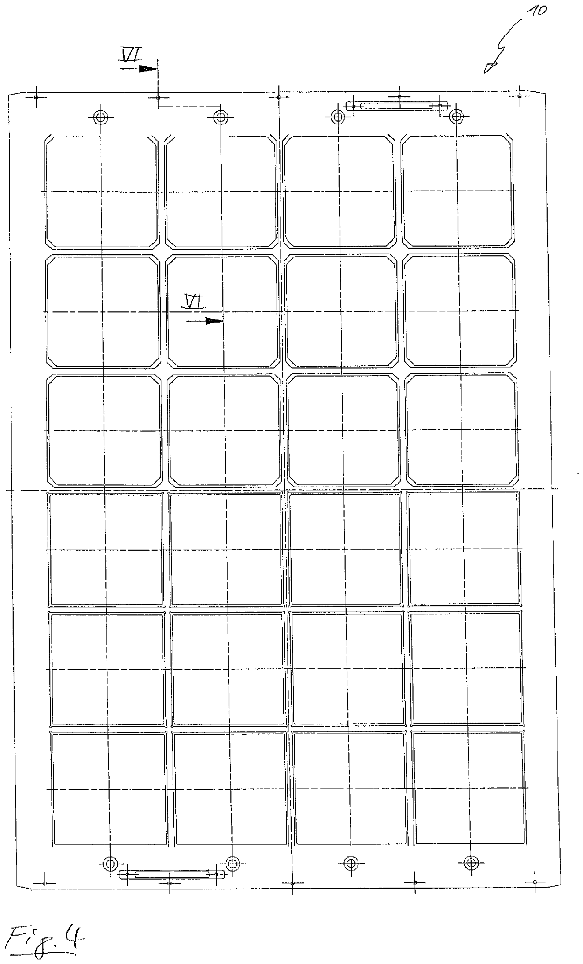

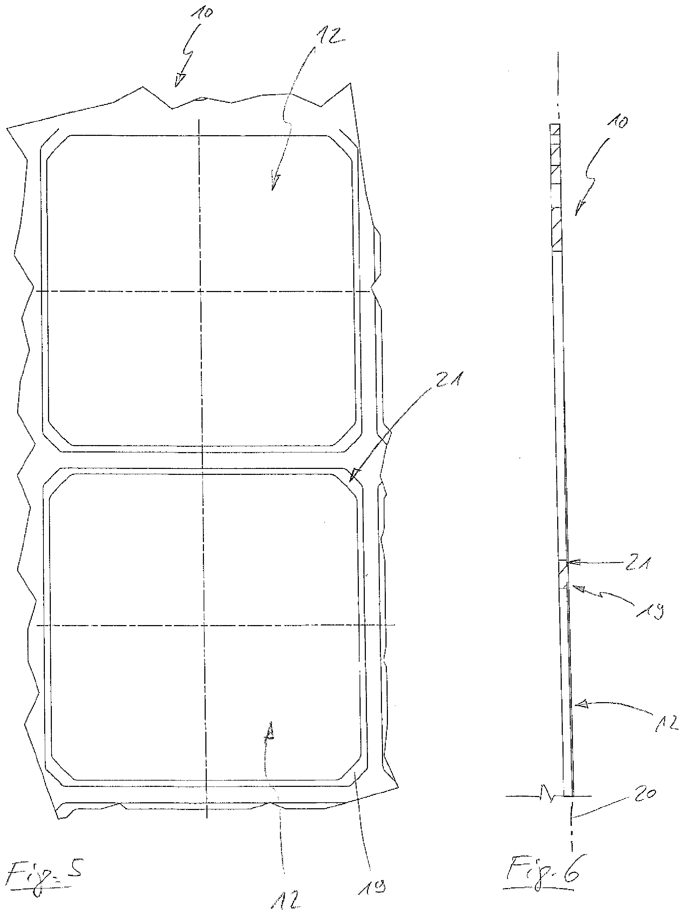

Eine Zusammenschau der **Fig. 4** bis **6** zeigt weitere Ansichten der Trägerplatte 10 aus **Fig. 1****.** Wie der **Fig. 5** zu entnehmen ist, weist die Ausnehmung 12 einen Absatz 19 auf, der in einer Ebene 20 des hier nicht dargestellten zweiten Fasergewebes ausgebildet ist. Eine Oberfläche 21 des Absatzes 19 wird daher unter anderem von dem zweiten Fasergewebe ausgebildet und weist infolge dessen eine besonders gute Oberflächenqualität auf. Der Absatz 19 wurde durch Fräsen beziehungsweise eine mechanische Bearbeitung ausgebildet.

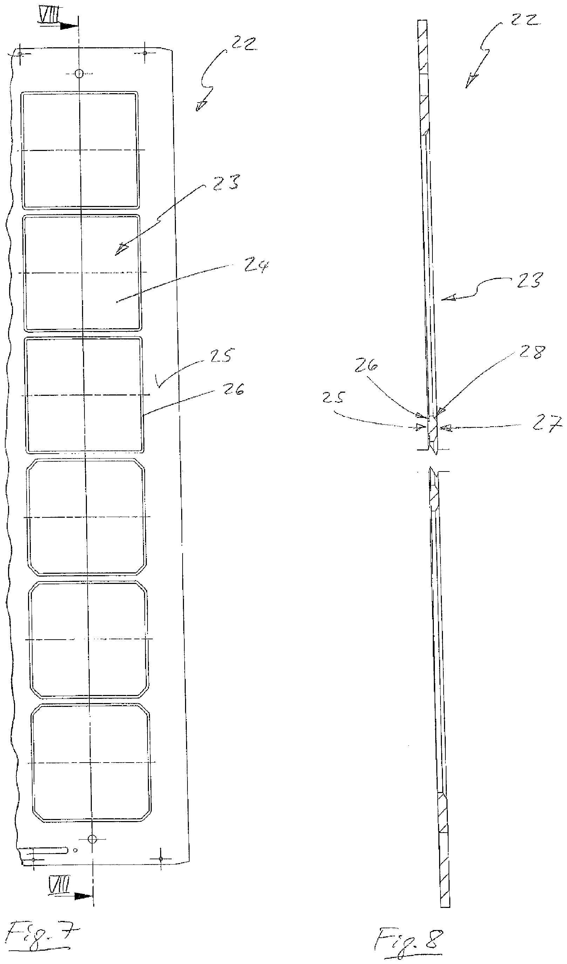

Die **Fig. 7** zeigt eine abschnittsweise Draufsicht einer Trägerplatte 22 und die **Fig. 8** eine Schnittansicht dieser Trägerplatte. Eine Ausnehmung 23 ist auch hier durch eine Durchgangsöffnung 24 ausgebildet, wobei auf einer Oberseite 25 der Trägerplatte 22 ein Absatz 26 zur Aufnahme eines hier nicht dargestellten Halbleitererzeugnisses, insbesondere Wafer, ausgebildet ist. An einer Unterseite 27 der Trägerplatte 22 ist im Bereich der Ausnehmungen 23 jeweils eine Fase 28 ausgebildet. Die Ausnehmung 23 befindet sich in einer hier nicht dargestellten Schicht mit 6 K-Filamentgarnen, und die Fase 28 in einer ersten Schicht mit 12 K-Filamentgarnen. Der Absatz 26 ist relativ zu der Oberseite 25 geringfügig geneigt.

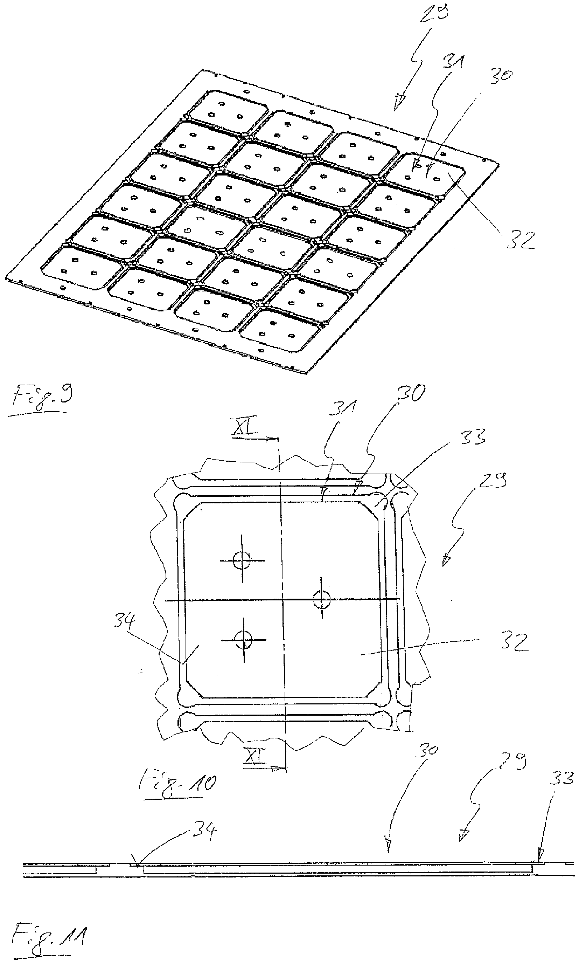

Eine Zusammenschau der **Fig. 9** bis **11** zeigt eine Trägerplatte 29 in verschiedenen Ansichten, wobei im Unterschied zu den zuvor beschriebenen Trägerplatten die Trägerplatte 29 eine Ausnehmung 30 aufweist, die als eine Tasche 31 ausgebildet ist. Die Ausnehmung 30 weist somit einen Boden 32 auf. Auch hier wurde ein Absatz 33 der Ausnehmung 30 mittels Fräsen in einer zweiten Schicht, die hier nicht näher ersichtlich ist, der Trägerplatte 29 ausgebildet. Der Boden 32 ist hingegen in einer ersten Schicht der Trägerplatte 29 angeordnet. Eine Oberfläche 34 des Absatzes 33 ist insbesondere zur Auflage eines Wafers vorgesehen.

## Patentansprüche

1. Verfahren zur Herstellung einer Trägerplatte (10, 13, 16, 22, 29) zur Aufnahme und Handhabung von Halbleitererzeugnissen oder Wafer, wobei aus Kohlenstofffasern ausgebildete Fasergewebelagen zu einem Stapel angeordnet werden, wobei die Fasergewebelagen mit einem Harz imprägniert werden, wobei das Harz ausgehärtet und pyrolysiert wird, wobei nachfolgend der Stapel grafitiert wird, **dadurch gekennzeichnet,**
**dass** eine erste Fasergewebelage des Stapels aus einem ersten Fasergewebe mit Filamentgarnen gleich oder größer 12 K und eine zweite Fasergewebelage des Stapels aus einem zweiten Fasergewebe mit Filamentgarnen gleich oder kleiner 6 K ausgebildet wird, wobei mittels einer spanenden Bearbeitung des Stapels eine Ausnehmung (12, 23, 30) zur Aufnahme eines Halbleitererzeugnisses ausgebildet wird, wobei die spanende Bearbeitung zumindest in einer Ebene (20) des zweiten Fasergewebes erfolgt.

2. Verfahren nach Anspruch 1,
**dadurch gekennzeichnet,**
**dass** das erste Fasergewebe mit Filamentgarnen gleich oder größer 800 tex und das zweite Fasergewebe mit Filamentgarnen gleich oder kleiner 400 tex ausgebildet wird.

3. Verfahren nach Anspruch 1 oder 2,
**dadurch gekennzeichnet,**
**dass** die Fasergewebelagen so zu dem Stapel angeordnet werden, dass eine erste Schicht (14, 17) der Trägerplatte (10, 13, 16, 22, 29) mit dem ersten Fasergewebe und eine zweite Schicht (15, 18) der Trägerplatte mit dem zweiten Fasergewebe ausgebildet werden.

4. Verfahren nach Anspruch 3,
**dadurch gekennzeichnet,**
**dass** zwei zweite Schichten (18) aus dem zweiten Fasergewebe ausgebildet werden, wobei die aus dem ersten Fasergewebe gebildete erste Schicht (17) zwischen den zweiten Schichten aus dem zweiten Fasergewebe angeordnet wird.

5. Verfahren nach einem der vorangehenden Ansprüche,
**dadurch gekennzeichnet,**
**dass** die erste Fasergewebelage mit einem Leinwand-Fasergewebe und die zweite Fasergewebelage mit einem Köper-Fasergewebe ausgebildet werden.

6. Verfahren nach einem der vorangehenden Ansprüche,
**dadurch gekennzeichnet,**
**dass** das erste Fasergewebe mit einem Gewichts- oder Volumenanteil von 2/3 bis 3/4 und das zweite Fasergewebe von 1/3 bis 1/4 zur Ausbildung der Trägerplatte (10, 13, 16, 22, 29) verwendet wird.

7. Verfahren nach einem der vorangehenden Ansprüche,
**dadurch gekennzeichnet,**
**dass** die Fasergewebe mit einer wechselnden Orientierung eines Faserverlaufs relativ zueinander zu dem Stapel angeordnet werden.

8. Verfahren nach einem der vorangehenden Ansprüche,
**dadurch gekennzeichnet,**
**dass** die Ausnehmung (12, 23, 30) so ausgebildet wird, dass die Ausnehmung als eine Tasche (31) in einer Oberseite (34) der Trägerplatte (13, 16, 29) ausgebildet ist oder als eine Durchgangsöffnung (11, 24) die Trägerplatte (10, 13, 16, 22) vollständig durchdringt.

9. Verfahren nach einem der vorangehenden Ansprüche,
**dadurch gekennzeichnet,**
**dass** an dem zweiten Fasergewebe mittels Fräsen eine Fase (28) und/oder ein Absatz (19, 26, 33) an der Ausnehmung (12, 23, 30) ausgebildet wird.

10. Verfahren nach einem der vorangehenden Ansprüche,
**dadurch gekennzeichnet,**
**dass** die Trägerplatte (10, 13, 16, 22, 29) frei von Pech ausgebildet wird.

11. Verfahren nach einem der vorangehenden Ansprüche,
**dadurch gekennzeichnet,**
**dass** als Harz ein Phenolharz verwendet wird.

12. Verfahren nach einem der vorangehenden Ansprüche,
**dadurch gekennzeichnet,**
**dass** nach der Pyrolyse und vor der Grafitierung eine Nachverdichtung des Stapels mit Harz erfolgt.

13. Verfahren nach einem der vorangehenden Ansprüche,
**dadurch gekennzeichnet,**
**dass** mittels Gasphasenabscheidung ein Infiltrieren und/oder Beschichten des grafitierten Stapels mit Pyrokohlenstoff erfolgt.

14. Verfahren nach einem der vorangehenden Ansprüche,
**dadurch gekennzeichnet,**
**dass** während des Pyrolysierens und/oder des Grafitierens der Stapel bereichsweise mit einer Kraft beaufschlagt wird.

15. Verfahren nach Anspruch 14,
**dadurch gekennzeichnet,**
**dass** der Stapel bereichsweise mit Grafitelementen beschwert wird.

16. Trägerplatte (10, 13, 16, 22, 29) zur Aufnahme und Handhabung von Halbleitererzeugnissen oder Wafer, wobei die Trägerplatte aus zu einem Stapel angeordneten Fasergewebelagen aus Kohlenstofffasern ausgebildet ist, wobei die Trägerplatte mit einer ausgehärteten und pyrolysierten Harzmatrix des Stapels ausgebildet und grafitiert ist,
**dadurch gekennzeichnet,**
**dass** eine erste Fasergewebelage des Stapels aus einem ersten Fasergewebe mit Filamentgarnen gleich oder größer 12 K und eine zweite Fasergewebelage des Stapels aus einem zweiten Fasergewebe mit Filamentgarnen gleich oder kleiner 6 K ausgebildet ist, wobei mittels einer spanenden Bearbeitung des Stapels eine Ausnehmung (12, 23, 30) zur Aufnahme eines Halbleitererzeugnisses ausgebildet ist, wobei die spanende Bearbeitung zumindest in einer Ebene (20) des zweiten Fasergewebes erfolgt ist.

17. Verwendung einer Trägerplatte (10, 13, 16, 22, 29) zur Aufnahme und Handhabung von Halbleitererzeugnissen oder Wafer, nach Anspruch 16.

## Claims

1. A method for manufacturing a carrier plate (10, 13, 16, 22, 29) for receiving and handling semiconductor products or wafers, wherein woven fiber layers made up of carbon fibers are arranged to form a stack, wherein the woven fiber layers are impregnated with a resin, wherein the resin is cured and pyrolized, wherein the stack is then graphitized,
**characterized in that**
a first woven fiber layer of the stack is formed out of a first woven fiber with filament yarns equal to or greater than 12 K, and a second woven fiber layer of the stack is formed out of a second woven fiber with filament yarns equal to or less than 6 K, wherein the stack is machined to form a recess (12, 23, 30) for receiving a semiconductor product, wherein machining takes place at least in a plane (20) of the second woven fabric.

2. The method according to claim 1,
**characterized in that**
the first woven fabric is formed with filament yarns equal to or greater than 800 tex, and the second woven fabric is formed with filament yarns equal to or less than 400 tex in design.

3. The method according to claim 1 or 2,
**characterized in that**
the woven fabric layers are arranged to form a stack in such a way that a first layer (14, 17) of the carrier plate (10, 13, 16, 22, 29) is formed with the first woven fabric, and a second layer (15, 18) of the carrier plate is formed with the second woven fabric.

4. The method according to claim 3,
**characterized in that**
two second layers (18) are formed out of the second woven fabric, wherein the first layer (17) formed out of the first woven fabric is arranged between the second layers comprised of the second woven fabric.

5. The method according to one of the preceding claims,
**characterized in that**
the first woven fiber layer is formed with a canvas woven fabric, and the second woven fiber layer is formed with a twill woven fabric.

6. The method according to one of the preceding claims,
**characterized in that**
the carrier plate (10, 13, 16, 22, 29) is formed using the first woven fabric with a weight or volume fraction of 2/3 to 3/4, and the second woven fabric with a weight or volume fraction of 1/3 to 1/4.

7. The method according to one of the preceding claims,
**characterized in that**
the woven fibers are arranged to form a stack with an alternating orientation of a fiber course relative to each other.

8. The method according to one of the preceding claims,
**characterized in that**
the recess (12, 23, 30) is formed such that the recess is formed as a bag (31) in an upper side (34) of the carrier plate (13. 16, 29) or it passes entirely through the carrier plate (10, 13, 16, 22) as a passage (11, 24).

9. The method according to any one of the preceding claims,
**characterized in that**
a chamfer (28) and/or ledge (19, 26, 33) is formed on the recess (12, 23, 30) on the second woven fabric via milling.

10. The method according to one of the preceding claims,
**characterized in that**
the carrier plate (10, 13, 16, 22, 29) is free of pitch in design.

11. The method according to one of the preceding claims,
**characterized in that**
a phenol resin is used as the resin.

12. The method according to one of the preceding claims,
**characterized in that**
the stack is repressed with resin after pyrolysis and before graphitization.

13. The method according to one of the preceding claims,
**characterized in that**
the graphitized stack is infiltrated and/or coated with pyrocarbon through vapor deposition.

14. The method according to one of the preceding claims,
**characterized in that**
regions of the stack are exposed to a force during pyrolysis and/or graphitization.

15. The method according to claim 14,
**characterized in that**
regions of the stack are weighed down with graphite elements.

16. A carrier plate (10, 13, 16, 22, 29) for receiving and handling semiconductor products or wafers, wherein the carrier plate consists of woven fiber layers comprised of carbon fibers arranged to form a stack, wherein the carrier plate is formed with a cured and pyrolized resin matrix of the stack and graphitized,
**characterized in that**
a first woven fiber layer of the stack consists of a first woven fabric with filament yarns equal to or greater than 12 K, and a second woven fabric of the stack consists of a second woven fiber with filament yarns equal to or less than 6 K, wherein the stack is machined to form a recess (12, 23, 30) for receiving a semiconductor product, wherein machining takes place at least in a plane (20) of the second woven fabric.

17. A use of a carrier plate (10, 13, 16, 22, 29) for receiving and handling semiconductor products or wafers according to claim 16.

## Revendications

1. Procédé pour la production d'une plaque de support (10, 13, 16, 22, 29) pour la réception et pour la manutention de produits de semi-conducteur ou de tranches, dans lequel des couches de tissu de fibre fait de fibres de carbone sont disposées en une pile, dans lequel les couches de tissu de fibre sont imprégnées avec une résine, dans lequel la résine est durcie et pyrolysée, dans lequel la pile est graphitée ensuite,
**caractérisé en ce**
**qu'**une première couche de tissu de fibre de la pile est formée par un premier tissu de fibre avec des fils continus égaux à ou plus supérieurs à 12 K et une deuxième couche de tissu de fibre de la pile est formée par un deuxième tissu de fibre avec des fils continus égaux à ou plus inférieurs à 6 K, dans lequel la pile est usinée de manière à former un évidement (12, 23, 30) pour la réception d'un produit semi-conducteur, dans lequel l'usinage se passe au moins dans un plan (20) du deuxième tissu de fibre.

2. Procédé selon la revendication 1,
**caractérisé en ce que**
le premier tissu de fibre est formé avec des fils continus égaux à ou plus supérieurs à 800 tex et le deuxième tissu de fibre est formé avec des fils continus égaux à ou plus inférieurs à 400 tex.

3. Procédé selon la revendication 1 ou la revendication 2,
**caractérisé en ce que**
les couches de tissu de fibre sont disposées en la pile de telle manière qu'une première couche (14, 17) de la plaque de support (10, 13, 16, 22, 29) est formée avec le premier tissu de fibre et une deuxième couche (15, 18) de la plaque de support est formée avec le deuxième tissu de fibre.

4. Procédé selon la revendication 3,
**caractérisé en ce que**
deux deuxième couches (18) sont formées par le deuxième tissu de fibre, dans lequel la première couche (17) formée par le premier tissu de fibre est disposée entre les deuxièmes couches fait du deuxième tissu de fibre.

5. Procédé selon l'une quelconque des revendications précédentes, **caractérisé en ce que**
la première couche de tissu de fibre est formée avec un tissu de fibre de toile et la deuxième couche de tissu de fibre est formée avec un tissu de fibre de sergé.

6. Procédé selon l'une quelconque des revendications précédentes, **caractérisé en ce que**
la plaque de support (10, 13, 16, 22, 29) est formée en utilisant le premier tissu de fibre avec une fraction pondérale ou volumique de 2/3 à 3/4 et le deuxième tissu de fibre avec une fraction pondérale ou volumique de 1/3 à 1/4.

7. Procédé selon l'une quelconque des revendications précédentes, **caractérisé en ce que**
les tissus de fibre sont disposés en la pile avec une orientation alternante de la longueur de fibre par rapport à un fibre à l'autre.

8. Procédé selon l'une quelconque des revendications précédentes, **caractérisé en ce que**
l'évidement (12, 23, 30) est formé de telle manière que
l'évidement est formé comme poche (31) dans un côté supérieur (34) de la plaque de support (13. 16, 29) ou il passe entièrement à travers la plaque de support (10, 13, 16, 22) comme passage (11, 24).

9. Procédé selon l'une quelconque des revendications précédentes, **caractérisé en ce**
**qu'**un biseau (28) et/ou un épaulement (19, 26, 33) est formé à l'évidement (12, 23, 30) sur le deuxième tissu de fibre au moyen du fraisage.

10. Procédé selon l'une quelconque des revendications précédentes, **caractérisé en ce que**
la plaque de support (10, 13, 16, 22, 29) est exempt de poix.

11. Procédé selon l'une quelconque des revendications précédentes, **caractérisé en ce**
**qu'**une résine de phénol est utilisée comme résine.

12. Procédé selon l'une quelconque des revendications précédentes, **caractérisé en ce**
**qu'**un recompactage de la pile est exécuté avec une résine après la pyrolyse et avant une graphitisation.

13. Procédé selon l'une quelconque des revendications précédentes, **caractérisé en ce que**
la pile graphitée est infiltrée et/ou couchée avec des fibres de carbone au moyen du dépôt chimique en phase vapeur.

14. Procédé selon l'une quelconque des revendications précédentes, **caractérisé en ce que**
des zones de la pile sont soumises à une force pendant la pyrolyse et/ou la graphitisation.

15. Procédé selon la revendication 14,
**caractérisé en ce que**
des zones de la pile sont chargées par des éléments de graphite.

16. Plaque de support (10, 13, 16, 22, 29) pour la réception et pour la manutention de produits de semi-conducteur ou de tranches, dans lequel la plaque de support est fait des couches de tissu de fibre faites de fibres de carbone et disposées en une pile, dans lequel la plaque de support est formée et graphitée avec une matrice de résine durcie et pyrolysée,
**caractérisé en ce**
**qu'**une première couche de tissu de fibre de la pile est formée par un premier tissu de fibre avec des fils continus égaux à ou plus supérieurs à 12 K et une deuxième couche de tissu de fibre de la pile est formée par un deuxième tissu de fibre avec des fils continus égaux à ou plus inférieurs à 6 K, dans lequel la pile est usinée de manière à former un évidement (12, 23, 30) pour la réception d'un produit semi-conducteur, dans lequel l'usinage se passe au moins dans un plan (20) du deuxième tissu de fibre.

17. Utilisation d'une plaque de support (10, 13, 16, 22, 29) pour la réception et pour la manutention de produits de semi-conducteur ou de tranches selon la revendication 16.
